# EUROPEAN PATENT APPLICATION

(11) **EP 2 669 958 A2**
(43) Date of publication of application: **04.12.2013**
(21) Application number: 12739539.0
(22) Date of filing: 30.01.2012
(51) Int. Cl.: H01L 31/042

(54) **SOLAR CELL**

(30) Priority: 28.01.2011 KR 20110008996
(71) Applicant: LG Innotek Co., Ltd., Seoul 100-714 (KR)
(72) Inventor: PARK, Gi Gon, Seoul 100-714 (KR)
(74) Representative: Novagraaf Technologies
(86) International application number: PCT/KR2012/000689
(87) International publication number: WO 2012/102593

(57) **Abstract**

Disclosed is a solar cell including upper and lower substrates facing each other, a semiconductor layer on a predetermined region of the lower substrate, and a pattern protruding from at least one of the upper and lower substrates. Various patterns are formed between the upper and lower substrates so that a contact area to an adhesive member, which is provided between the upper and lower substrates, is increased, thereby improving adhesive force between the upper and lower substrates.

## Description

### Technical Field

The embodiment relates to a solar cell.

### Background Art

In general, a solar cell converts solar energy into electrical energy. The solar cell has been extensively used for the commercial purpose as energy consumption is increased recently.

According to the related art, the solar cell is fabricated by sequentially laminating a back electrode layer, a light absorbing layer, a transparent electrode layer and an upper substrate on a lower substrate in which the upper substrate horizontally adheres to the uppermost end of the solar cell.

However, since only one adhesive member is provided between the upper substrate and the lower substrate, there is limitation in adhesive force between the upper and lower substrates and the reliability against moisture penetration is degraded.

### Disclosure

### Technical Problem

The embodiment provides a solar cell capable of improving an adhesive force between an upper substrate and a lower substrate while enhancing the reliability against moisture penetration.

### Technical Solution

A solar cell according to one embodiment includes upper and lower substrates facing each other, a semiconductor layer on a predetermined region of the lower substrate, and a pattern protruding from at least one of the upper and lower substrates.

### Advantageous Effects

According to the solar cell of the embodiment, various patterns are formed between the upper and lower substrates so that a contact area to an adhesive member, which is provided between the upper and lower substrates, is increased, thereby improving adhesive force between the upper and lower substrates.

In addition, according to the solar cell of the embodiment, the shape of the pattern can be variously modified to lengthen the moisture penetration path so that the reliability against moisture penetration can be improved.

### Description of Drawings

FIG. 1 is a sectional view showing a solar cell according to the embodiment.

FIG. 2 is a perspective view showing a lower substrate having a pattern according to the embodiment.

FIG. 3 is a sectional view showing a semiconductor layer formed on a substrate according to the embodiment.

FIG. 4 is a partially sectional view showing a pattern formed on a substrate according to the embodiment.

FIGS. 5 to 7 are sectional views showing modified examples of a lower substrate having a pattern according to the embodiment.

### Best Mode

### Mode for Invention

In the description of the embodiments, it will be understood that when each panel, wire, cell, device, surface, or pattern is referred to as being "on" or "under" another panel, wire, cell, device, surface, or pattern, it can be "directly" or "indirectly" on the other lens, unit, part, hole, protrusion, groove or layer or one or more intervening layers may also be present. Such a position of elements will be explained with reference to the drawings. The thickness and size of each layer shown in the drawings may be exaggerated, omitted or schematically drawn for the purpose of convenience or clarity. In addition, the size of elements does not utterly reflect an actual size.

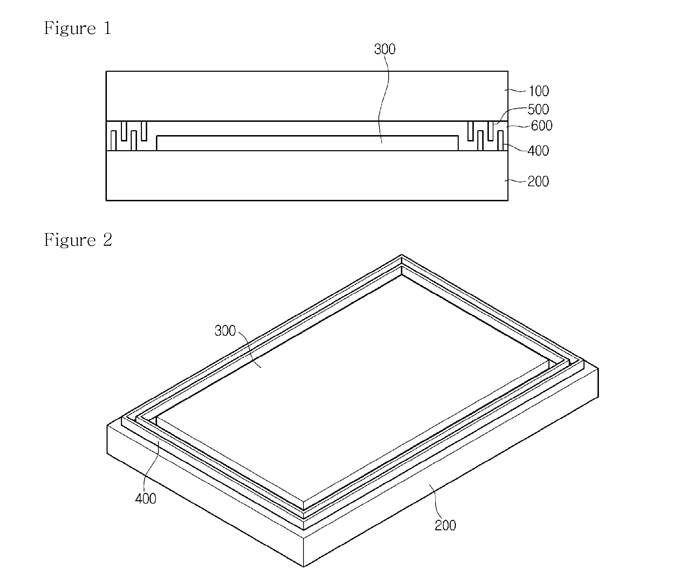

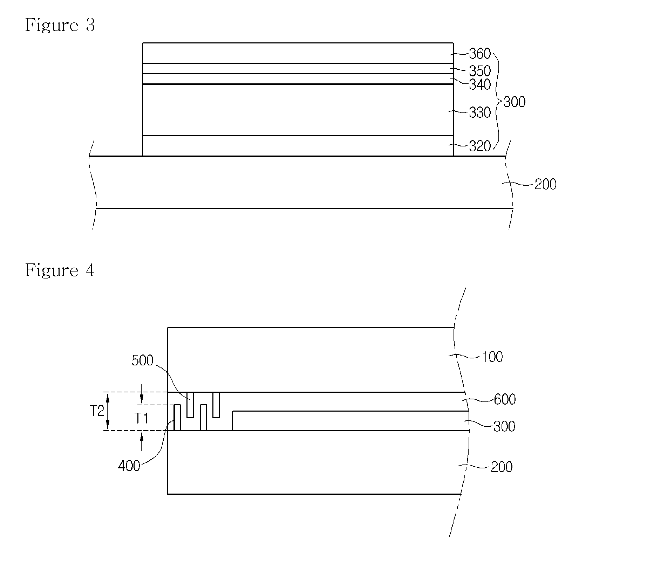

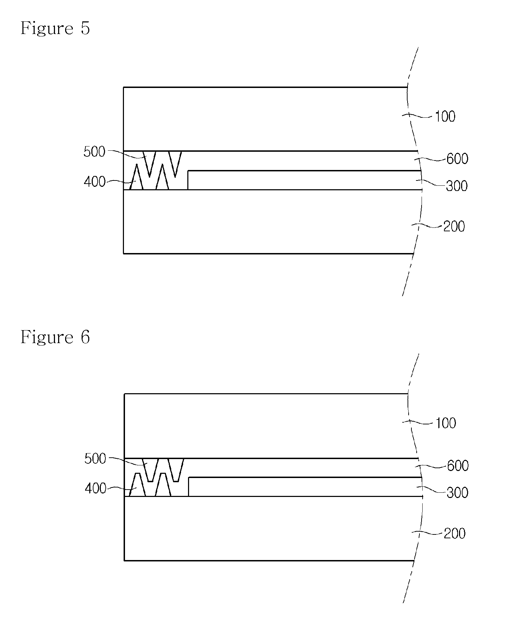

FIG. 1 is a sectional view showing a solar cell according to the embodiment, FIG. 2 is a perspective view showing a lower substrate having a pattern according to the embodiment, FIG. 3 is a sectional view showing a semiconductor layer formed on a substrate according to the embodiment, FIG. 4 is a partially sectional view showing a pattern formed on a substrate according to the embodiment and FIGS. 5 to 7 are sectional views showing modified examples of a lower substrate having a pattern according to the embodiment.

Referring to FIGS. 1 to 4, the solar cell according to the embodiment includes an upper substrate 100, a lower substrate 200, a semiconductor layer 300 on a predetermined region of the lower substrate 200, and a first pattern 400 formed on a region of the lower substrate 100 where the semiconductor layer 300 is not formed. In addition, a second pattern 500 may be further provided on the substrate 100 corresponding to the first pattern 400.

The upper substrate 100 and the lower substrate 200 are arranged to face each other in the longitudinal direction. The upper substrate 100 and the lower substrate 200 have rectangular plate shapes and can be formed by using transparent glass. The upper substrate 100 and the lower substrate 200 may be rigid or flexible. In particular, a soda lime glass substrate including sodium components is preferably used as the lower substrate 200 to improve the power efficiency during the manufacturing process.

Besides the glass substrate, a plastic substrate including PET (Polyethylene Terephthalate), PEN (Polyethylenenaphthelate), PP (Polypropylene) or TAC (Tri Acethl Cellulose), or a metal substrate can be used for the upper substrate 100 and the lower substrate 200. In addition, the upper substrate 100 and the lower substrate 200 may be formed by using mutually different materials.

The semiconductor layer 300 is formed between the upper substrate 100 and the lower substrate 200. As shown in FIG. 2, the semiconductor layer 300 can be formed by laminating a plurality of layers on a central region of the lower substrate 200.

As shown in FIG. 3, the semiconductor layer 300 includes a back electrode layer 320, a light absorbing layer 330, and a transparent electrode layer 360. A first buffer layer 340 and a second buffer layer 350 may be further formed between the light absorbing layer 330 and the transparent electrode layer 360.

The back electrode layer 320 is formed on the central region of the lower substrate 200 to serve as an n type electrode. The back electrode layer 320 may include Mo. In addition, the back electrode layer 320 may be formed by using at least one of Ni, Au, Al, Cr, W and Cu, which are conductive materials, and may be prepared as at least two layers by using the same metal or mutually different metals.

The light absorbing layer 330 is formed on the back electrode layer 320. The light absorbing layer 330 incudes group I-III-VI compounds and can be formed by using at least one of CIGS, CIS, CGS and CdTe.

For instance, the light absorbing layer 330 may include one selected from the group consisting of CdTe, CuInSe2, Cu(In,Ga)Se2, Cu(In,Ga)(Se,S)2, Ag(InGa)Se2, Cu(In,Al)Se2, and CuGaSe2.

The first buffer layer 340 and the second buffer layer 350 are sequentially formed on the light absorbing layer 330. The first buffer layer 340 can be formed by using a material including CdS and has an energy bandgap in the range of about 1.9 eV to about 2.3 eV, which is an intermediate level between the back electrode layer 320 and the transparent electrode layer 360. The first buffer layer 340 may be prepared as at least two layers.

The second buffer layer 350 is formed by using a ZnO material having high resistance. The second buffer layer 350 can prevent the insulation and impact damage with respect to the transparent electrode layer 360.

The transparent electrode layer 360 is formed on the second buffer layer 350. The transparent electrode layer 360 is formed by using a transparent conductive material, such as aluminum doped zinc oxide (AZO (ZnO:Al)). In addition to AZO, the transparent electrode layer 360 may include at least one of ZnO, SnO₂ and ITO.

Although it has been described that the semiconductor layer 300 is formed as one cell, the embodiment is not limited thereto. For instance, the semiconductor layer 300 may be formed as a plurality of cells.

Referring back to FIG. 1, an adhesive member 600 may be prepared between the lower substrate 200 formed with the semiconductor layer 300 and the upper substrate 100 in order to seal a space between the lower substrate 200 and the upper substrate 100. The adhesive member 600 may be prepared as a film or a liquid-phase adhesive material.

The first pattern 400 according to the embodiment is formed on the lower substrate 200. The lower substrate 200 includes a central region and a peripheral region surrounding the central region. The first pattern 400 is formed on the peripheral region of the lower substrate 100. That is, the first pattern 400 is formed along the peripheral region of the lower substrate 100. In detail, the first pattern 400 is formed along the peripheral region of the lower substrate 100 which does not interfere with the semiconductor layer 300. In addition, the second pattern is formed on a predetermined region of the upper substrate 100 corresponding to the first pattern formed on the lower substrate 200.

As shown in FIG. 4, the first pattern 400 according to the embodiment has a rectangular sectional shape and protrudes upward from the lower substrate 200. A height T1 of the first pattern 400 may be 1/2 or more based on a height T2 of a space between the upper substrate 100 and the lower substrate 200. In the same manner, the second pattern 500 protrudes downward from the upper substrate 100 and has a height corresponding to the height of the first pattern.

The first pattern 400 formed on the lower substrate 200 and the second pattern formed on the upper substrate 500 may be alternately aligned toward the center region of the substrate. In detail, the first pattern 400 and the second pattern 500 may be directed toward the space between the upper substrate 100 and the lower substrate 200. Thus, the first pattern 400 and the second pattern 500 may enlarge the contact area with respect to the adhesive member 600 and lengthen the moisture penetration path.

The first pattern 400 and the second pattern 500 may be meshed with each other. In addition, the first pattern 400 and the second pattern 500 may be alternately aligned. Accordingly, first pattern 400 and the second pattern 500 may improve the adhesive force between the upper substrate 100 and the lower substrate 200 and prevent the moisture from penetrating between the upper substrate 100 and the lower substrate 200.

Although it has been described that the first pattern 400 and the second pattern 500 are alternately aligned, the embodiment is not limited thereto. The first pattern 400 and the second pattern 500 may be variously aligned. In addition, although it has been described that the first pattern 400 and the second pattern 500 have the same height, the embodiment is not limited thereto. For instance, the first pattern 400 and the second pattern 500 may have mutually different heights.

Although it has been described that the first pattern 400 and the second pattern 500 have the rectangular sectional shape, the embodiment is not limited thereto. For instance, the first pattern 400 and the second pattern 500 may have sectional shapes as shown in FIGS. 5 to 7.

As shown in FIG. 5, the solar cell according to the embodiment includes the upper substrate 100 and the lower substrate 200, which face each other, and the semiconductor layer 300 prepared as a multi-layer is formed on the lower substrate 200.

The first pattern 400 is formed on the peripheral region of the lower substrate 200 such that the first pattern 400 may not interfere with the semiconductor layer 300 and the first pattern 400 may have the rectangular sectional shape. The height of the first pattern 400 may be 1/2 or more based on the height of the space between the upper substrate 100 and the lower substrate 200, but the embodiment does not limit the height of the first pattern 400.

In addition, the second pattern 500 is formed on the upper substrate 100 to have a shape corresponding to a shape of the first pattern 400, and preferably, the second pattern 500 is alternately aligned with the first pattern 400.

In addition, as shown in FIG. 6, the first pattern 400 formed on the lower substrate 200 may be alternately aligned with the second pattern 500 formed on the upper substrate 100 and the first and second patterns 400 and 500 may have polygonal sectional shapes, such as trapezoidal shapes.

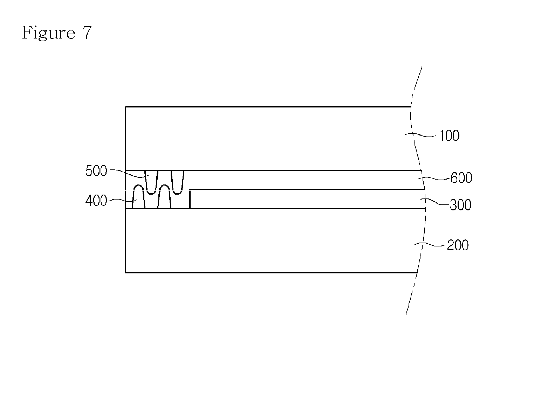

Further, as shown in FIG. 7, the first pattern 400 formed on the lower substrate 200 may be alternately aligned with the second pattern 500 formed on the upper substrate 100 and the first and second patterns 400 and 500 may have hemispherical sectional shapes. In addition, the first and second patterns 400 and 500 may have elliptical sectional shapes.

As shown in FIGS. 5 to 7, if the shape of the first and second patterns 400 and 500 is modified, the contact area to the adhesive member 600, which bonds the upper substrate 100 to the lower substrate 200, may be enlarged and the moisture penetration path may be lengthened.

Therefore, due to the modified shape and the alignment of the first and second patterns 400 and 500, the adhesive force between the upper substrate 100 and the lower substrate 200 can be improved and the reliability against the moisture penetration can be remarkably improved.

Although various shapes of the first pattern 400 and the second pattern 500 have been described above with reference to embodiments, the alignment of the first pattern 400 and the second pattern 500 is also within the scope of the embodiment.

In addition, although it has been described that the patterns are formed on both of the upper and lower substrates, the embodiment is not limited thereto. For instance, the pattern may be formed on only one of the upper and lower substrates.

Although an exemplary embodiment of the disclosure has been described for illustrative purposes, those skilled in the art will appreciate that various modifications, additions and substitutions are possible, without departing from the scope and spirit of the invention as disclosed in the accompanying claims.

## Claims

1. A solar cell comprising:
upper and lower substrates facing each other;
a semiconductor layer on a predetermined region of the lower substrate; and
a pattern protruding from at least one of the upper and lower substrates.

2. The solar cell of claim 1, wherein the pattern includes a first pattern protruding from the lower substrate.

3. The solar cell of claim 2, wherein the lower substrate includes a central region where the semiconductor layer is formed and a peripheral region surrounding the central region, and the first pattern is formed at the peripheral region.

4. The solar cell of claim 2, wherein a height of the first pattern is 1/2 or more based on a height of a space between the upper substrate and the lower substrate.

5. The solar cell of claim 2, wherein the first pattern has at least one of a polygonal shape, a hemispheric shape and an elliptical shape.

6. The solar cell of claim 3, wherein the pattern includes a second pattern protruding from the upper substrate.

7. The solar cell of claim 6, wherein the second pattern is positioned in a region corresponding to a region of the lower substrate where the first pattern is formed.

8. The solar cell of claim 6, wherein a height of the second pattern is 1/2 or more based on a height of a gap between the upper substrate and the lower substrate.

9. The solar cell of claim 6, wherein the second pattern has at least one of a polygonal shape, a hemispheric shape and an elliptical shape.

10. The solar cell of claim 6, wherein the first and second patterns are directed toward a space between the upper and lower substrates.

11. The solar cell of claim 6, wherein the first and second patterns face each other.

12. The solar cell of claim 6, wherein the first and second patterns are meshed with each other.

13. The solar cell of claim 6, wherein the first and second patterns are alternately arranged with each other.
